# EUROPÄISCHE PATENTSCHRIFT

(11) **EP 0 993 627 B1**
(45) Veröffentlichungstag und Bekanntmachung des Hinweises auf die Patenterteilung: **21.04.2004**
(21) Anmeldenummer: 98942489.0
(22) Anmeldetag: 02.07.1998
(51) Int. Cl.: G03F 1/14, G03F 7/20

(54) **ANORDNUNG ZUR ÜBERTRAGUNG VON STRUKTUREN**
DEVICE FOR TRANSFERRING STRUCTURES
DISPOSITIF PERMETTANT DE TRANSFERER DES STRUCTURES

(30) Priorität: 04.07.1997 DE 19728662
(43) Veröffentlichungstag der Anmeldung: 19.04.2000
(73) Patentinhaber: Infineon Technologies AG, 81669 München (DE)
(72) Erfinder: RUF, Alexander, D-01127 Dresden (DE)
(74) Vertreter: Kindermann, Peter, Dipl.-Ing.
(86) Internationale Anmeldenummer: PCT/DE1998/001834
(87) Internationale Veröffentlichungsnummer: WO 1999/001586

(56) Entgegenhaltungen:
- EP-A- 0 707 237
- WO-A-98/12603
- PATENT ABSTRACTS OF JAPAN vol. 017, no. 669 (P-1657), 9. Dezember 1993 & JP 05 224396 A (KURARAY CO LTD), 3. September 1993
- ANONYMOUS: "Utilizing Optical Lithography in the Sub-Micron Dimensional Regime." IBM TECHNICAL DISCLOSURE BULLETIN, Bd. 33, Nr. 5, Oktober 1990, Seiten 187-188, XP000107428 New York, US
- ROGERS J A ET AL: "USING AN ELASTOMERIC PHASE MASK FOR SUB-100 NM PHOTOLITHOGRAPHY IN THE OPTICAL NEAR FIELD" APPLIED PHYSICS LETTERS, Bd. 70, Nr. 20, 19. Mai 1997, Seiten 2658-2660, XP000694781
- SCHMID H ET AL: "LIGHT-COUPLING MASKS FOR LENSLESS, SUB-WAVELENGTH OPTICAL LITHOGRAPHY" APPLIED PHYSICS LETTERS, Bd. 72, Nr. 19, 11. Mai 1998, Seiten 2379-2381, XP000755967

## Beschreibung

Die Erfindung betrifft eine Anordnung zur Übertragung von Strukturen, ein Verfahren zu ihrer Herstellung sowie ihre Verwendung im Bereich der Halbleitertechnologie.

Auf letztgenanntem Gebiet spielt die Miniaturisierung der Abmessungen eine immer wichtigere Rolle. Vor allem bei Speicherbauteilen wird an einer Verkleinerung gearbeitet, um eine höhere Speicherdichte zu erreichen. Bei der Herstellung solcher Speicherbauteile sind photolithographische Belichtungen zur Abbildung der gewünschten Strukturen von entscheidender Wichtigkeit. Insbesondere um Strukturbreiten von unter 0,25 µm erreichen zu können, muß die Auflösung herkömmlicher Belichtungsverfahren deutlich verbessert werden.

Nach heutigem Stand der Technik (siehe z.B. "Silicon Processing for the VLSI Era Volume 1 - Process Technology", S. Wolf, R.N. Tauber, Lattice Press, Sunset Beach, California, USA) werden beispielsweise zur Herstellung von Strukturen mit 0,35 µm Breite Projektionsmasken eingesetzt, die mit einem Stepper um den Faktor 5 oder 10 verkleinert auf einen mit Fotoresist beschichteten Wafer übertragen werden. Die Auflösung wird dabei durch die von der Wellenoptik vorgegebenen Grenzen beschränkt. Hier sind Beugungsphänomene und das Abbesche-Auflösungskriterium zu nennen. In der konventionellen optischen Lithographie ist es nicht möglich, Strukturen zu erzeugen, deren Größe geringer ist als etwa die Wellenlänge des Lichts, welches zur Belichtung verwendet wird.

Um die Auflösung zu verbessern und Strukturbreiten unter 0,25 µm zu ermöglichen, sind grundsätzlich zwei Lösungswege vorgeschlagen worden.
Zum einen wurde Licht kürzerer Wellenlänge eingesetzt, um zu einer verbesserten Auflösung zu gelangen. Als Beispiel kann die Verwendung von Excimer-Lasern mit einer Wellenlänge von 248, 195 oder 157 nm genannt werden (siehe z.B. "Nanolithography and its prospects as a manufacturing technology", R.F.W. Pease, J. Vac. Sci. Technol. B 10(1) 1992, 278-284). Dieser Lösungsansatz erfordert jedoch einen erheblichen apparativen Aufwand (Excimer-Laser mit Spezialoptik) und ist entsprechend teuer. Außerdem müssen spezielle Fotolacke mit hoher Empfindlichkeit für die eingesetzte Wellenlänge verwendet werden.

Eine weitere Alternative zur Verbesserung der Auflösung besteht im Einsatz von Phasenmasken, die durch gezielte Kombination der Phasendrehungen von Licht beim Durchgang durch optisch transparente oder teilweise absorbierende Medien unterschiedlicher Dicke zu Phasenverschiebungen führen. Die durch die Phasenverschiebungen bewirkte interferierende Verstärkung und Auslöschung führt zu Abbildungen mit verbesserter Auflösung.

Die Herstellung solcher Phasenmasken erfordert jedoch einen außerordentlich großen Rechenaufwand, um das grundsätzliche Design der Masken zu entwerfen. Zudem müssen die Masken durch experimentelle Befunde weiter optimiert werden. Auch dieser Weg der Auflösungsverbesserung ist also zeitraubend und teuer.

Eine neuere Entwicklung, mit der die optische Auflösung verbessert werden kann, ist die Rastersonden-Technik, die sich beispielsweise der STM-Technik bedient (STM = Scanning Tunneling Microscopy). Diese Technik ist beispielsweise in "Patterning of an electron beam resist with a scanning tunneling microscope operating in air", K. Kragler, E. Günther, R. Leuschner, G. Falk, H. von Seggern, G. Saemann-Ischenko, Thin Solid Films 264 (1995) 259-263, und in dem bereits genannten Artikel von R.F.W. Pease beschrieben.

In "Near-field optics: light for the world of nano-scale science", D.W. Pohl, Thin solid films 264 (1995) 250-254, wird die Überwindung des Abbeschen-Auflösungslimits durch optische Rasternahfeld-Mikroskopie beschrieben. Dabei wird eine Probenoberfläche mit einer dünnen Spitze abgerastert, die eine sehr kleine optische Apertur aufweist, die in geringem Abstand über die Probenoberfläche geführt wird. Die Spitze ist in der Regel eine metallisch bedampfte Glasfaser. Die erreichbare Auflösung hängt von dem optischen Durchmesser der Apertur und dem Abstand zur Probe ab und kann auf unter λ/20 verbessert werden. Dazu ist es allerdings erforderlich, den Abstand zwischen Apertur und Probenoberfläche auf einige nm genau einzustellen, um das Arbeiten im optischen Nahfeld zu gewährleisten. Bei Verwendung von Glasfasern eignet sich zur Abstandskontrolle die Scherkraftdetektion.

Derartige Glasfaserspitzen sind auch zur Belichtung einer Struktur eingesetzt worden. Dabei wird die Spitze über das zu belichtende Substrat, z.B. einen Fotolack, geführt und dieser lokal belichtet. Die erreichbaren Stukturbreiten liegen bei ca. 80 nm an Luft ("Scanning near-field optical lithography" (SNOL), S. Wegscheider, A. Kirsch, J. Mlynek, G. Krausch, Thin Solid Films 264 (1995) 264-267) und 50 nm im Vakuum ("Optical near-field lithography on hydrogen-passivated silicon surfaces", S. Madsen, M. Müllenborn, K. Birkelund, F. Grey; Appl. Phys. Lett. 69 (4) (1996) 544-546). Weitere Verbesserungen der Auflösung durch Verbesserung des Herstellungsverfahrens für die Glasfaserspitzen sind denkbar.

Würde man versuchen, eine Probenoberfläche mit einer einzelnen derartigen Spitze zu belichten, wäre dies extrem zeitaufwendig wäre und käme damit für einen kontinuierlichen Betrieb im Bereich der Halbleitertechnologie nicht in Frage. Auch in diesem Fall wäre zudem eine Abstandskontrolle mittels Scherkraftdetektion notwendig.

Der Herstellungsprozeß für die Glasfaserspitzen ist zudem sehr schlecht reproduzierbar, so daß übereinstimmende Spitzen mit definierter optischer Apertur nur schwer erhältlich sind. Dies hat zur Folge, daß Spitzenarrays aus mehreren Spitzen kaum verwendet werden können. Derartige Arrays würden es zudem erfordern, daß die Lichtzufuhr zu jeder der Spitzen gesondert gesteuert und außerdem der Abstand jeder einzelnen Spitze zur Probenoberfläche gesondert eingestellt werden müßte. Der apparative Aufwand hierfür wäre enorm.

Aus W. Noell, M. Abraham, K. Mayr, A. Ruf, J. Barenz, O. Hollrichter, O. Marti und P. Güthner; "Micromachined Aperture Probe Tip for Multifunctional Scanning Probe Microscopy", Appl. Phys. Lett. 70 (1997) 1236-1238, und der DE-A-195 09 903 ist zwar ein vereinfachtes Verfahren zur Herstellung von Spitzen für die Rasternahfeld-Mikroskopie bekannt. Die Spitzen werden unter Zuhilfenahme der Dünnschichttechnik aus einer Siliciumnitridschicht herausgeätzt. Die oben in Zusammenhang mit einzelnen Spitzen oder Spitzenarrays beschriebenen Probleme bestehen jedoch weiterhin.

**Aufgabe** der Erfindung ist es daher, eine Möglichkeit zur optischen Belichtung von zu strukturierenden Substraten zu schaffen, bei welcher eine möglichst gute Auflösung und Strukturbreiten von bevorzugt unter 350 nm erreicht werden können. Die Belichtung sollte möglichst einfach, schnell, kostengünstig und ohne großen apparativen Aufwand durchführbar sein.

Die Lösung der Aufgabe gelingt mit der Anordnung zur Übertragung von Strukturen auf eine zu strukturiende Schicht gemäß Anspruch 1, welche auf einfache Weise durch das Verfahren gemäß Anspruch 12 herstellbar ist. Die Erfindung betrifft weiterhin die Verwendung der Anordnung gemäß Anspruch 20. Vorteilhafte Ausgestaltungen und Varianten ergeben sich aus den Unteransprüchen, der Beschreibung und den beiliegenden Zeichnungen.

Insbesondere betrifft die Erfindung eine Anordnung, welche geeignet ist, sehr feine Strukturen photolithographisch auf ein Substrat zu übertragen. Die Belichtung erfolgt dabei unter Verwendung der in der optischen Rasternahfeld-Mikroskopie angewandten Techniken, die es ermöglichen, die optische Auflösungsgrenze des Abbe-Limits zu überwinden, indem das Nahfeld sehr kleiner optischer Aperturen in die Nähe der Substratoberfläche gebracht wird. Voraussetzung für die sehr hohe Auflösung sind möglichst kleine optische Aperturen.

In der erfindungsgemäßen Anordnung, die eine effiziente Belichtung der zu strukturierenden Schichten bei ausgezeichneter Auflösung ermöglicht, werden die sehr kleinen Aperturen, die bevorzugt eine Aperturbreite von unter 250 nm besitzen, durch die Austrittsapertur bzw. Austrittsaperturen eines Strahlungsleiters gebildet. In einem oberen, von einer Anordnungsgrundfläche abgewandten Bereich weist die strahlungsleitende Struktur bevorzugt eine Strukturbreite von unter 250 nm auf.

Bevorzugt umfaßt die strahlungsleitende Struktur ein Strahlungsmedium, das von einer Schicht aus strahlungsundurchlässigem Material umgeben ist. Besitzt das Strahlungsmedium jedoch einen ausreichend Brechungsindex, so kann es auch ohne strahlungsundurchlässige Schicht als strahlungsleitende Struktur verwendet werden.

Ist eine Schicht aus strahlungsundurchlässigem Material vorgesehen, so können die Austrittsaperturen können auch durch die Schicht aus strahlungsundurchlässigem Material definiert werden. Die Anordnung ist dann auf der Seite der strahlungsleitenden Struktur mit einer strahlungsundurchlässigen Schicht versehen und zwar derart, daß im oberen Bereich der strahlungsleitenden Struktur Austrittsaperturen der gewünschten Strukturbreite frei bleiben.

Wegen seines hohen Brechungsindex ist Siliciumnitrid (Si₃N₄) ein bevorzugtes Material für das Strahlungsmedium. Weitere geeignete Materialien sind Siliciumdioxid und Siliciumcarbid. Besonders zweckmäßig wird das strahlungsdurchlässige Material durch chemische Gasphasenabscheidung und insbesondere PECVD (Plasma-Enhanced Chemical Vapour Deposition) abgeschieden.

Das strahlungsdurchlässige Material kann in Verbindung mit einem Basiselement (Träger) oder ohne ein solches verwendet werden. Beispielsweise kann das strahlungsdurchlässige Material auf einen ebenfalls strahlungsdurchlässigen Träger aufgebracht sein. Ein bevorzugter Träger besteht aus Glas.
Es können jedoch auch alle sonst im Bereich der Photolithographie verwendeten gängigen Materialien verwendet werden, sofern sie die Anforderungen an die nötige optische Durchlässigkeit erfüllen.

Wird ein Träger aus einem optisch undurchlässigen Material verwendet, weist er im Bereich, der den Austrittsaperturen der Anordnung bzw. Maske gegenüber liegt, ebenfalls Durchlaßöffnungen auf.

Weiter ist es möglich, während der Herstellung der Maske einen Träger als Bearbeitungsunterlage zu verwenden und diesen nach Fertigstellung der Maske wieder zu entfernen.

Eine weitere Variante besteht darin, die strahlungsleitende Struktur als Hohlraum auszubilden. Das Medium, durch welches die Belichtungsstrahlung zwischen den Flanken aus optisch undurchlässigem Material, welche die erhabenen Strukturen begrenzen, hindurchtritt, ist dann also in der Regel Luft bzw. die Atmosphäre, in welcher die Belichtung des Substrates durchgeführt wird. Es könnte zur Abstimmung der Brechungsindexes aber auch eine Flüssigkeit sein.

Als strahlungsundurchlässiges Material, welches die Anordnung abdeckt, eignet sich besonders ein Metall, insbesondere ein plasmonaktives Metall wie z.B. Aluminium, Titan, Platin oder Silber. Ein bevorzugtes Metall ist Aluminium. Zweckmäßig wird das Metall auf die Maske mit den Strahlungsleitern aufgedampft oder aufgesputtert.

Das strahlungsundurchlässige Material kann zusätzlich beschichtet sein, z.B. mit einem Oxid, Carbid oder Nitrid. Geeignete Materialien sind beispielsweise Siliciumdioxid oder Siliciumnitrid.

Die erfindungsgemäße Anordnung eignet sich hervorragend für die Übertragung sehr feiner Strukturen in einem kontinuierlichen Verfahren und ist damit Rasterspitzen weit überlegen. Es ist ohne weiteres möglich, Strukturen mit einer Strukturbreite von unter 100 nm zu erzeugen, und entsprechend ist die Aperturbreite in der Anordnung dann geringer als 100 nm. Bevorzugt werden die strahlungsleitenden Strukturen in der erfindungsgemäßen Anordnung so ausgeführt, daß ihr Krümmungsradius im oberen, von der Anordnungsgrundfläche abgewandten Bereich nicht größer als 50 nm ist.

Ein weitere Vorteil der erfindungsgemäßen Anordnung besteht darin, daß sie neben Aperturen einer Öffnungsbreite von unter 250 nm auch solche einer Öffnungsbreite von 250 nm oder mehr aufweisen kann. Beide Strukturtypen lassen sich mit der erfindungsgemäßen Anordnung in einem einzigen Belichtungsschritt auf die zu strukturiende Schicht übertragen. Konventionelle und Nanostrukturen lassen sich mit der erfindungsgemäßen Maske also äußerst effektiv und kostengünstig erzeugen.

Besonders zweckmäßig erfolgt die Herstellung der erfindungsgemäßen Nanostruktur-Maske derart, daß Aperturen von über und unter 250 nm gleichzeitig bzw. parallel hergestellt werden.

Die Auflösung in der optischen Rasternahfeld-Mikroskopie wird neben der Größe der optischen Apertur auch durch den Abstand zur Probe bestimmt. Um eine gute Auflösung zu erreichen, muß der Abstand zur Probe auf einige nm genau eingestellt werden. Bei den bekannten Rasterspitzen erfolgt die Abstandskontrolle, wie erwähnt, durch Scherkraftdetektion. Entsprechend kann auch der Abstand der erfindungsgemäßen Anordnung zu der zu strukturierenden Schicht gesteuert werden.

Möglich ist weiterhin eine interferometrische Abstandskontrolle an den Stellen der Schicht, die nicht strukturiert werden müssen.

In einer besonders bevorzugten Ausführungsform wird die erfindungsgemäße Anordnung jedoch so ausgeführt, daß die oberen Bereiche des Strahlungsmediums über die Beschichtung aus strahlungsundurchlässigem Material vorstehen und als Abstandhalter zu der zu strukturierenden Schicht dienen. Die Vorsprungshöhe wird also zweckmäßig entsprechend dem bei der Belichtung des Substrates erforderlichen Abstand der Maske zur Schicht gewählt. Zur Belichtung kann die Maske dann einfach auf die zu strukturiende Schicht aufgesetzt werden. Eine komplizierte Abstandskontrolle ist nicht erforderlich.

Die erfindungsgemäße Anordnung kann durch ein Verfahren hergestellt werden, welches die folgenden Schritte umfaßt:
- eine Schicht aus strahlungsdurchlässigem Material wird bereitgestellt,
- eine Maske wird auf die Schicht aus strahlungsdurchlässigem Material aufgebracht,
- unter Verwendung der Maske wird die Schicht aus strahlungsdurchlässigem Material strukturiert, um eine strahlungsleitende Struktur mit einer von einer Anordnungsgrundfläche abgewandten Austrittapertur zu erzeugen, und
die Maske wird entfernt.

Dabei ist es bevorzugt, wenn auf die strukturierte Schicht aus strahlungsdurchlässigem Material eine eine Schicht aus strahlungsundurchlässigem Material so aufgebracht wird, daß eine von der Anordnungsgrundfläche abgewandten Austrittapertur erhalten bleibt.

Weiterhin ist es bevorzugt, wenn die Schicht aus strahlungsdurchlässigem Material durch eine isotrope Ätzung strukturiert wird, so daß die Maske unterätzt wird und das erzeugte Strahlungsmedium an der Austrittsapertur eine Strukturbreite von weniger als 250 nm, insbesondere von weniger als 100 nm aufweist.

Vorteilhafterweise kann als Maske zur Strukturierung der Schicht aus strahlungsdurchlässigem Material eine Fotolackschicht verwendet werden.

Die Maske zur Strukturierung der Fotolackschicht kann dabei auf herkömmliche Weise hergestellt werden, da die Strukturbreiten in der Größenordnung über 350 nm liegen können, welche sich mit Hilfe herkömmlicher Belichtungsverfahren erzeugen lassen. Das Strukturmuster entspricht dem gewünschten Strukturmuster, das im zu behandelnden Substrat erzeugt werden soll, in verbreiterter Form. Eine geeignete Maske zur Belichtung des Fotolacks bei der Herstellung der erfindungsgemäßen Anordnung ist beispielsweise eine herkömmliche Chrommaske mit Strukturen einer Breite von über 350 nm.

Das Muster dieser Maske kann zweckmäßig durch einen Standardfotoprozeß auf die Fotolackschicht übertragen werden, die bevorzugt auf die zu strukturierende Schicht aufgebracht wurde. Anschließend wird die Maskierungsstruktur in einem isotropen Naß- oder Trockenätzprozeß unterätzt, so daß die Strahlungsmediem, die aus der zu strukturierenden Schicht herausgeätzt werden, eine Breite haben, die deutlich unterhalb der Strukturbreite der Fotomaske liegt. Bevorzugt liegt die Strukturbreite der Strahlungsmedien in deren oberen Kantenbereich unter 250 nm, und bevorzugt ist der Krümmungsradius der Kanten dieser Strahlungsmedien nicht größer als 50 nm.

Zum Ätzen der Strahlungsmedien kann zweckmäßig das reaktive Ionenätzen (RIE) eingesetzt werden. Geeignete Ätzverfahren sind dem Fachmann grundsätzlich bekannt. Als Beispiele geeigneter Ätzmittel können fluor- oder chlorhaltige Verbindungen genannt werden. Die Ätzzeit hängt beispielsweise von der Art der Maskierungsstruktur und der Dicke der zu ätzenden Schicht ab.

Der Ätzvorgang kann einerseits so durchgeführt werden, daß eine durchgehende Schicht des strukturierten Materials erhalten bleibt. Diese durchgehende Schicht definiert dann die Anordnungsgrundfläche. Andererseits ist es möglich, die zu strukturierende Schicht so weit zu ätzen, daß Material nur im Bereich der Strahlungsmedien stehen bleibt. Letztere Variante eignet sich besonders in Fällen, in denen die Anordnungsgrundfläche von einem Basiselement definiert werden soll.

Das Aufbringen der optisch undurchlässigen Schicht, welche vorzugsweise ein metallisches Material ist, erfolgt zweckmäßig durch Aufdampfen oder Sputtern. Um die Apertur und/oder die Höhe, mit welcher die Strahlungsleiter über die optisch undurchlässige Schicht überstehen, auf die gewünschte Größe einzustellen, können das optisch undurchlässige Material und/oder die Strahlungsmedien auf an sich bekannte Weise zurückgeätzt werden. Auch ein Rücksputtern der Metallschicht ist möglich.

Eine weitere Möglichkeit der Erzeugung der Austrittsapertur definierter Aperturbreite ist das chemisch-mechanische Polieren (CMP) der Anordnungsoberseite nach dem Aufbringen des optisch undurchlässigen Materials. Hierbei wird solange Material im oberen, von der Anordnungsgrundfläche abgewandten Bereich abgetragen, bis die Austrittsapertur die gewünschte Aperturbreite aufweisen. Besonders bevorzugt ist es, vor der CMP-Behandlung zunächst das optisch undurchlässige Material mit einer weiteren Schicht aus Metalloxid, -carbid oder - nitrid zu versehen, wobei das Metall nicht auf das Metall der undurchlässigen Schicht beschränkt ist.

Die CMP-Behandlung kann für die jeweiligen Schichten selektiv durchgeführt werden, so daß beispielsweise die äußere Schicht aus Metalloxid, -carbid oder -nitrid mit einer anderen Rate abgetragen wird als die darunter liegende optisch undurchlässige Schicht oder die Strahlungsmedien. Bei selektiver Abtragung können Abstandhalter definierter Höhe erhalten bleiben. Führt man dagegen die CMP-Behandlung nicht selektiv durch, werden sowohl optisch undurchlässiges Material als auch das von diesem eingeschlossene Material des Strahlungsmediums und gegebenenfalls Metalloxid, -carbid oder -nitrid entfernt. Eine Abstandskontrolle zum Substrat durch die über das optisch undurchlässige Material vorstehenden erhabenen Strukturen ist in diesem Fall also nicht realisierbar. Dafür bietet die CMP-Behandlung den Vorteil, daß eine sehr plane Anordnungsoberfläche erhalten werden kann, die eine Abstandskontrolle zum zu belichtenden Substrat nach einer konventionellen Methode wie der Scherkraftdetektion oder Interferometrie sehr erleichtert.

Die einzelnen vorstehend beschriebenen Verfahrensschritte sind dem Fachmann grundsätzlich bekannt, so daß eine eingehendere Erläuterung hier nicht erforderlich ist. Einzelheiten zu den einzelnen Verfahrensschritten der Herstellung von Spitzen bzw. unterätzten Strukturen aus Siliciumnitrid können beispielsweise nachgelesen werden in: A. Ruf "Neue Sensoren für die Rasterkraftmikroskopie", Dissertation TH Darmstadt, Dissertations Druck Darmstadt GmbH 1996, ISBN 3-931713-04-0. Die Herstellung von metallbeschichteten Siliciumnitridspitzen ist beschrieben in W. Noell et al., Appl. Phys. Lett. 70 (1997) 1236-1238.

Soll eine erfindungsgemäße Anordnung hergestellt werden, bei der die strahlungsleitende Strukturen als Hohlräume ausgebildet sind, geht man zunächst grundsätzlich so vor, wie es vorstehend beschrieben wurde. In einem Herstellungsstadium nach dem Aufbringen des optisch undurchlässigen Materials, beispielsweise nach Erzeugung der Aperturen definierter Größe, wird dann jedoch das in den strahlungsleitenden Strukturen durch die Flanken aus optisch undurchlässigem Material eingeschlossene Material entfernt. Dies kann durch einen geeigneten Ätzvorgang geschehen, bei dem das eingeschlossene Material ganz oder teilweise entfernt wird, so daß eine Austrittsapertur geeigneter Größe entsteht.

Sind die strahlungsleiten Strukturen auf einem Basiselement ausgebildet, das aus einem optisch undurchlässigen Material besteht, erstrecken sich entsprechende Durchlaßöffnungen durch dieses Basiselement hindurch.

Im beschriebenen Fall, bei dem die strahlungsleitenden Strukturen als Hohlräume ausgebildet sind, ist es nicht erforderlich, daß die im erfindungsgemäßen Verfahren zunächst hergestellte zu strukturierende Schicht aus einem optisch durchlässigen Material besteht.

Bleibt die zu strukturierende Schicht dagegen erhalten und werden die Strahlungsmedien aus dem Material der zu strukturierenden Schicht gebildet, wird ein optisch durchlässiges Material verwendet.

Die erfindungsgemäßen Anordnungen lassen sich wie herkömmliche Chrommasken zur Belichtung von Substraten aus dem Bereich der Halbleitertechnologie einsetzen, jedoch können durch die Nahfeldspektroskopie und die subwellenlängengroßen Aperturen sehr viel bessere Auflösungen erreicht und entsprechend erheblich feinere Strukturierungen durchgeführt werden. Strukturbreiten unter 100 nm sind ohne weiteres möglich.

Zur Belichtung wird die erfindungsgemäße Anordnung über der zu strukturierenden Schicht, z.B. einer Fotolackschicht, angeordnet, und von der Rückseite der Anordnung wird beispielsweise Licht eingestrahlt, welches durch die subwellenlängengroßen Austrittsaperturen auf die zu strukturiende Schicht trifft. Auf diese Weise können Muster definierter Art und Größe in einem Belichtungsschritt auf die zu strukturierende Schicht übertragen werden. Der im Bereich der optischen Nahfeldspektroskopie erforderliche geringe Spalt zwischen Apertur und zu strukturiender Schicht kann entweder auf herkömmliche Weise, z.B. durch Scherkraftbestimmung, oder mit Hilfe der als Abstandhalter ausgebildeten Strahlungsmedien eingehalten werden. In letzterem Fall wird die Maske unmittelbar auf die zu strukturierende Schicht aufgesetzt. Diese Variante hat zudem den Vorteil, die Aperturen gegen mechanische Beschädigung zu schützen und eine sehr leicht reproduzierbare Abstandskontrolle und damit exakt reproduzierbare Belichtungen zu ermöglichen. Zudem ist es möglich, bei der Verwendung der erfindungsgemäßen Anordnung auf teure Laser, wie sie beispielsweise bei der DUV-Lithographie (DUV = Deep Ultraviolet) verwendet werden, für die Belichtung zu verzichten.

Sowohl bei der Herstellung der erfindungsgemäßen Anordnung als auch bei ihrer Verwendung können herkömmliche Geräte und Verfahren eingesetzt werden. Rechnerischer Aufwand, wie bei der Herstellung von Phasenmasken, ist nicht erforderlich. Die erfindungsgemäßen Anordnungen können darüber hinaus auch zum Erzeugen sehr feiner und dicht beieinander liegender Strukturen eingesetzt werden, wie sie z.B. bei DRAM-Zellen-feldern vorhanden sind. Derartige Strukturen sind selbst dann herstellbar, wenn bei der Produktion der erfindungsgemäßen Anordnung beim Herstellen einer Maskierungsstruktur zum Unterätzen zwischen zwei Stegen oder Löchern kein ausreichender Platz bleibt. In diesem Fall ist es möglich, die Periodizität der zu belichtenden Struktur auszunutzen und mehrfach nacheinander mit derselben Anordnung zu belichten, wobei beim zweiten Mal die erfindungsgemäße Anordnung um den erforderlichen Gitterabstand versetzt wird. Das Verschieben der Anordnung kann auf an sich bekannte Weise erfolgen, z.B. mit Hilfe eines Verschiebetisches mit interferometrisch kontrollierter Verschiebeeinheit.

Die Erfindung soll im folgenden anhand einer Zeichnung näher erläutert werden. Darin zeigen schematisch
- Fig. 1: eine erfindungsgemäße Anordnung im Teil-Querschnitt, und
- Fig. 2 bis 6: erläutern das erfindungsgemäße Verfahren zur Herstellung einer erfindungsgemäßen Anordnung.

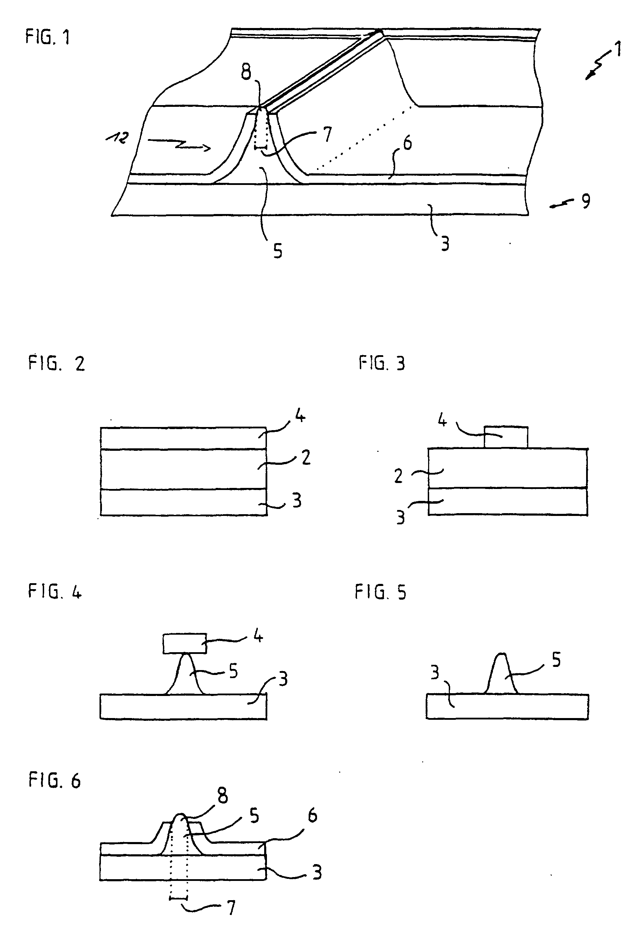

In Fig. 1 ist eine erfindungsgemäße Anordnung 1 dargestellt, welche ein optisch durchlässiges Basiselement 3 umfaßt, das sich über die gesamte Anordnungsgrundfläche 9 erstreckt und in diesem Fall eine Glasplatte ist, auf welcher die Strahlungsmedien 5 ausgebildet sind, welche aus Siliciumnitrid bestehen. Auf der Seite dieser Strahlungsmedien 5 ist die Nanostruktur-Maske 1 mit einem optisch undurchlässigen, aber bevorzugt plasmonaktiven Material 6, hier Aluminium, beschichtet. Bei plasmonaktiven Materialien können sich Oberflächenwellen bilden, wodurch zusätzliche Strahlung zu der Austrittsapertur geführt wird. Die Strahlungsmedien 5 und die sie bedeckende Schicht 6 bilden die strahlungsleitende Struktur 12.

In ihrem oberen Bereich sind die Strahlungsmedien 5 nicht mit Aluminium beschichtet, so daß Austrittsaperturen 8 mit einer Aperturbreite 7 von unter 250 nm gebildet werden. Die Strahlungsmedien 5 ragen etwas über die Aluminiumschicht 6 heraus und können als Abstandhalter dienen, wenn die - in diesem Fall linienförmigen - Strukturen der erfindungsgemäßen Anordnung auf eine Fotoresistschicht oder ähnliches übertragen werden sollen. Hierzu wird die erfindungsgemäße Anordnung mit den Austrittsaperturen 8 in Richtung auf den Fotoresist unmittelbar auf diesen aufgesetzt, wodurch sich die Aperturen 8 im gewünschten Abstand zum Resist befinden.

Fig. 2 bis 6 verdeutlichen das erfindungsgemäße Verfahren zur Herstellung einer erfindungsgemäßen Anordnung.

Fig. 2 zeigt im Querschnitt ein Ausgangsmaterial mit einem Basiselement 3 aus optisch durchlässigem Material, hier Glas, auf welchem auf an sich bekannte Weise eine Schicht aus optisch durchlässigem Siliciumnitrid 2 und eine Fotolackschicht 4 abgeschieden wurden.

Fig. 3 verdeutlicht eine Folgestufe, in der die Fotolackschicht 4 auf herkömmliche Weise, z.B. durch Belichtung mit einer Chrommaske, strukturiert wurde.

Im Nachfolgeschritt wird nun die Siliciumnitridschicht geätzt. Erfindungsgemäß wird dabei die Fotolackschicht 4 unterätzt, so daß von der strukturierbaren Schicht 2 Strahlungsleiter 5 erhalten bleiben, deren Strukturbreite geringer ist als die Breite der Fotolackstrukturen und die unter 250 nm liegt.

In Fig. 5 wird eine weitere Stufe gezeigt, in der der Fotolack 4 entfernt ist.

Fig. 6 schließlich zeigt die erfindungsgemäße nach Aufbringen der optisch undurchlässigen Schicht 6, hier aus Aluminium. Die Schicht ist dergestalt aufgebracht, daß einerseits eine Aperturbreite 7 von unter 250 nm erreicht wird und andererseits die Höhe, mit welcher die Strahlungsmedien 5 über das Metall vorstehen, im wesentlichen dem gewünschten Abstand der Apertur 8 zu der Oberfläche des Substrats entspricht, welches mit Hilfe der Nanostruktur-Maske belichtet werden soll.

## Patentansprüche

1. Anordnung zur Übertragung von Strukturen auf eine zu strukturiende Schicht,
**dadurch gekennzeichnet, daß** zumindest eine von einer Anordnungsgrundfläche (9) vorstehende strahlungsleitende Struktur (12) vorgesehen ist, die eine Strahlung zu einer von der Anordnungsgrundfläche (9) abgewandten Austrittsapertur (8) führt und die in ihrer Form der zu übertragenden Struktur angepaßt ist.

2. Anordnung gemäß Anspruch 1, dadurch gekennzeichnet, daß die strahlungsleitende Struktur (12) ein Strahlungsmedium (5) umfaßt, welches bevorzugt Siliciumnitrid, Siliciumcarbid oder Siliciumdioxid enthält.

3. Anordnung gemäß Anspruch 1 oder 2, dadurch gekennzeichnet, daß die strahlungsleitende Struktur (12) eine strahlungsundurchlässige, bevorzugt plasmonaktive Schicht (6) umfaßt.

4. Anordnung gemäß Anspruch 3, dadurch gekennzeichnet, daß die strahlungsundurchlässige Schicht (6) ein Metall, insbesondere Aluminium, Titan, Platin oder Silber enthält.

5. Anordnung gemäß Anspruch 4, dadurch gekennzeichnet, daß das Metall aufgedampft oder aufgesputtert ist.

6. Anordnung gemäß einem der Ansprüche 3 bis 5, **dadurch gekennzeichnet, daß** auf der strahlungsundurchlässigen Schicht (6) eine Schicht aus einem Oxid, Carbid oder Nitrid aufgebracht ist.

7. Anordnung gemäß einem der Ansprüche 1 bis 6,
**dadurch gekennzeichnet,**
**daß** die strahlungsleitende Struktur (12) als Hohlraum ausgebildet ist.

8. Anordnung gemäß einem der Ansprüche 1 bis 7, **dadurch gekennzeichnet, daß** ein Basiselement (3) vorgesehen ist, das bevorzugt ein strahlungsdurchlässiges Material umfaßt.

9. Anordnung gemäß einem der Ansprüche 1 bis 8, **dadurch gekennzeichnet**, die Strukturbreite (7) der Austrittsapertur (8) in vorgegebenen Bereichen der Anordnung geringer als 250 nm, insbesondere geringer als 100 nm ist.

10. Anordnung gemäß einem der Ansprüche 1 bis 9, dadurch gekennzeichnet, daß die strahlungsleitende Struktur (12) an der Austrittsapertur (8) in vorgegebenen Bereichen einen Kantenkrümmungsradius von nicht mehr als 50 nm besitzt.

11. Anordnung gemäß einem der Ansprüche 3 bis 10, dadurch **gekennzeichnet**, daß im Bereich der Austrittsapertur (8) das Strahlungsmedium (5) gegenüber der strahlungsundurchlässigem Schicht (6) so weit vorsteht, daß die Höhe des nicht von der strahlungsundurchlässigen Schicht (6) bedeckten Strahlungsmediums (5) im wesentlichen dem gewünschten Belichtungsabstand entspricht.

12. Verfahren zur Herstellung einer Anordnung gemäß einem der Ansprüche 1 bis 11 mit den Schritten:
- eine Schicht (2) aus strahlungsdurchlässigem Material wird bereitgestellt,
- eine Maske (4) wird auf die Schicht (2) aus strahlungsdurchlässigem Material aufgebracht,
- unter Verwendung der Maske (4) wird die Schicht (2) aus strahlungsdurchlässigem Material strukturiert, um eine strahlungsleitende Struktur (5, 12) mit einer von einer Anordnungsgrundfläche (9) abgewandten Austrittapertur (8) zu erzeugen, und
die Maske (4) wird entfernt.

13. Verfahren gemäß Anspruch 12, **dadurch gekennzeichnet, daß** auf die strukturierte Schicht (2) aus strahlungsdurchlässigem Material eine eine Schicht (6) aus strahlungsundurchlässigem Material so aufgebracht wird, daß eine von der Anordnungsgrundfläche (9) abgewandten Austrittapertur (8) erhalten bleibt.

14. Verfahren gemäß Anspruch 12 oder 13, **dadurch gekennzeichnet, daß** die Schicht (2) aus strahlungsdurchlässigem Material durch eine isotrope Ätzung strukturiert wird, so daß die Maske (4) unterätzt wird und das erzeugte Strahlungsmedium (5) an der Austrittsapertur (8) eine Strukturbreite (7) von weniger als 250 nm, insbesondere von weniger als 100 nm aufweist.

15. Verfahren gemäß Anspruch 14, **dadurch gekennzeichnet, daß** das Ätzen der Schicht (2) aus strahlungsdurchlässigem Material durch reaktives Ionenätzen erfolgt.

16. Verfahren gemäß einem der Ansprüche 15 bis 18,
**dadurch gekennzeichnet,**
**daß** auf die Schicht (6) aus strahlungsundurchlässigem Material eine Schicht aus einem Oxid, Carbid oder Nitrid aufgebracht wird.

17. Verfahren gemäß einem der Ansprüche 12 bis 16,
**dadurch gekennzeichnet,**
**daß** die Austrittsapertur (8) durch chemisch-mechanisches Polieren erzeugt wird.

18. Verfahren gemäß einem der Ansprüche 13 bis 17, dadurch **gekennzeichnet**, daß die Höhe der über das strahlungsundurchlässige Material (6) herausragenden Bereiche der strukturierten Schicht (2) durch Rückätzen der strukturierten Schicht (2) und/oder durch Rückätzen oder Rücksputtern des strahlungsundurchlässige Materials (6) eingestellt wird.

19. Verfahren gemäß einem der Ansprüche 12 bis 18,
**dadurch gekennzeichnet,**
**daß** die Schicht (2) aus strahlungsdurchlässigem Material auf einem Basiselement (3) bereitgestellt wird.

20. Verwendung der Anordnung gemäß einem der Ansprüche 1 bis 11 zur Erzeugung von strukturierten Schichten in dem Bereich der Halbleitertechnologie.

21. Verwendung der Anordnung gemäß Anspruch 20 zur Belichtung im optischen Nahfeld unter Einhaltung eines definierten Abstandes zwischen der Austrittsapertur (8) und der Oberfläche der zu strukturienden Schicht.

22. Verwendung der Anordnung gemäß Anspruch 20 oder 21 zur mehrfachen Belichtung der zu strukturienden Schicht, wobei die Anordnung zwischen den Belichtungen um eine vorgegebene Distanz versetzt wird.

## Claims

1. Arrangement for transferring structures to a layer to be patterned,
**characterized in that** at least one radiation-conducting structure (12) projecting from an arrangement base area (9) is provided, which guides a radiation to an exit aperture (8) facing away from the arrangement base area (9) and whose shape is matched to that of the structure to be transferred.

2. The arrangement as claimed in Claim 1, **characterized in that** the radiation-conducting structure (12) comprises a radiation medium (5) preferably containing silicon nitride, silicon carbide or silicon dioxide.

3. The arrangement as claimed in Claim 1 or 2, **characterized in that** the radiation-conducting structure (12) comprises a radiation-opaque, preferably plasmon-active layer (6).

4. The arrangement as claimed in Claim 3, **characterized in that** the radiation-opaque layer (6) contains a metal, in particular aluminium, titanium, platinum or silver.

5. The arrangement as claimed in Claim 4, **characterized in that** the metal is vapour-deposited on or sputtered on.

6. The arrangement as claimed in one of Claims 3 to 5, **characterized in that** a layer made of an oxide, carbide or nitride is applied to the radiation-opaque layer (6).

7. The arrangement as claimed in one of Claims 1 to 6;
**characterized in that** the radiation-conducting structure (12) is designed as a cavity.

8. The arrangement as claimed in one of Claims 1 to 7, **characterized in that** a base element (3) is provided, which preferably comprises a radiation-transmissive material.

9. The arrangement as claimed in one of Claims 1 to 8, **characterized in that** the structure width (7) of the exit aperture (8) in predetermined regions of the arrangement is less than 250 nm, in particular less than 100 nm.

10. The arrangement as claimed in one of Claims 1 to 9, **characterized in that** the radiation-conducting structure (12) has, at the exit aperture (8), in predetermined regions, an edge radius of curvature of not more than 50 nm.

11. The arrangement as claimed in one of Claims 3 to 10, **characterized in that**, in the region of the exit aperture (8), the radiation medium (5) projects with respect to the radiation-opaque layer (6) to such an extent that the height of the radiation medium (5) not covered by the radiation-opaque layer (6) essentially corresponds to the desired exposure distance.

12. Method for fabricating an arrangement as claimed in one of Claims 1 to 11, having the following steps:
- a layer (2) made of radiation-transmissive material is provided,
- a mask (4) is applied to the layer (2) made of radiation-transmissive material,
- using the mask (4), the layer (2) made of radiation-transmissive material is patterned in order to produce a radiation-conducting structure (5, 12) with an exit aperture (8) facing away from an arrangement base area (9), and
- the mask (4) is removed.

13. The method as claimed in Claim 12, **characterized in that** a layer (6) made of radiation-opaque material is applied to the patterned layer (2) made of radiation-transmissive material in such a way that an exit aperture (8) facing away from the arrangement base area (9) is preserved.

14. The method as claimed in Claim 12 or 13, **characterized in that** the layer (2) made of radiation-transmissive material is patterned by isotropic etching, with the result that the mask (4) is undercut and the radiation medium (5) produced has, at the exit aperture (8), a structure width (7) of less than 250 nm, in particular of less than 100 nm.

15. The method as claimed in Claim 14, **characterized in that** the layer (2) made of radiation-transmissive material is etched by means of reactive ion etching.

16. The method as claimed in one of Claims 15 to 18,
**characterized in that** a layer made of an oxide, carbide or nitride is applied to the layer (6) made of radiation-opaque material.

17. The method as claimed in one of Claims 12 to 16,
**characterized in that** the exit aperture (8) is produced by chemical mechanical polishing.

18. The method as claimed in one of Claims 13 to 17, **characterized in that** the height of those regions of the patterned layer (2) which project beyond the radiation-opaque material (6) is set by etching back the patterned layer (2) and/or by etching back or sputtering back the radiation-opaque material (6).

19. The method as claimed in one of Claims 12 to 18,
**characterized in that** the layer (2) made of radiation-transmissive material is provided on a base element (3).

20. Use of the arrangement according to one of Claims 1 to 11 for producing patterned layers in the field of semiconductor technology.

21. Use of the arrangement according to Claim 20 for exposure in the optical near field while maintaining a defined distance between the exit aperture (8) and the surface of the layer to be patterned.

22. Use of the arrangement according to Claim 20 or 21 for multiple exposure of the layer to be patterned, the arrangement being offset by a predetermined distance between the exposures.

## Revendications

1. Dispositif de transfert de structures sur une couche à structurer,
**caractérisé en ce qu'**il est prévu au moins une structure (12) conductrice du rayonnement en avant d'une surface (9) de base du dispositif, menant un rayonnement à une ouverture (8) de sortie éloignée de la surface (9) de base du dispositif et adaptée dans sa forme à la structure à transférer.

2. Dispositif suivant la revendication 1, **caractérisé en ce que** la structure (12) conduisant du rayonnement comprend un milieu (5) de rayonnement qui renferme, de préférence, du nitrure de silicium, du carbure de silicium ou du dioxyde de silicium.

3. Dispositif suivant la revendication 1 ou 2, **caractérisé en ce que** la structure (12) conduisant du rayonnement comprend une couche (6) imperméable au rayonnement, de préférence active par plasma.

4. Dispositif suivant la revendication 3, **caractérisé en ce que** la couche (6) imperméable au rayonnement renferme un métal, notamment de l'aluminium, du titane, du platine ou de l'argent.

5. Dispositif suivant la revendication 4, **caractérisé en ce que** l'on dépose le métal par dépôt en phase vapeur ou par pulvérisation cathodique.

6. Dispositif suivant l'une des revendications 3 à 5, **caractérisé en ce que** l'on dépose sur la couche (6) imperméable à du rayonnement une couche en un oxyde, en un carbure ou en un nitrure.

7. Dispositif suivant l'une des revendications 1 à 6, **caractérisé en ce que** la structure (12) conduisant du rayonnement est constituée sous la forme d'une cavité.

8. Dispositif suivant l'une des revendications 1 à 7, **caractérisé en ce que** l'on prévoit un élément (3) de base qui renferme de préférence une matière perméable au rayonnement.

9. Dispositif suivant l'une des revendications 1 à 8, **caractérisé en ce que** la largeur (7) de la structure de l'ouverture (8) de sortie est, dans des parties données en avant du dispositif, plus petite que 250 nm, notamment plus petite que 100 nm.

10. Dispositif suivant l'une des revendications 1 à 9, **caractérisé en ce que** la structure (12) conduisant du rayonnement a, à l'ouverture (8) de sortie, dans des parties données à l'avance, un rayon de courbure de bord qui n'est pas supérieur à 50 nm.

11. Dispositif suivant l'une des revendications 3 à 10, **caractérisé en ce que** dans la partie de l'ouverture (8) de sortie, le milieu (5) de rayonnement est si en saillie par rapport à la couche (6) imperméable à du rayonnement que la hauteur du milieu (5) de rayonnement qui n'est pas recouvert par la couche imperméable à du rayonnement correspond sensiblement à la distance d'exposition souhaitée.

12. Procédé de production d'un dispositif suivant l'une des revendications 1 à 11 comprenant les stades :
- on prépare une couche (2) en une matière perméable à du rayonnement,
- on dépose un masque (4) sur la couche en une matière perméable à du rayonnement,
- en utilisant le masque (4), on structure la couche (2) en matière perméable au rayonnement pour produire une structure (5, 12) conductrice du rayonnement ayant une ouverture (8) de sortie éloignée d'une surface (9) de base du dispositif, et
on élimine le masque (4).

13. Procédé suivant la revendication 12, **caractérisé en ce que** l'on dépose, sur la structure (2) structurée en matière perméable à du rayonnement, une couche (6) en une matière imperméable à du rayonnement, de façon à laisser subsister une ouverture (8) de sortie éloignée de la surface (9) de base du dispositif.

14. Procédé suivant la revendication 12 ou 13, **caractérisé en ce que** l'on structure la couche (2) en matière perméable à du rayonnement par une attaque isotrope, de façon à ce que le masque (4) subisse une attaque latérale et de façon à ce que le milieu (5) de rayonnement produit ait, à l'ouverture (8) de sortie, une largeur (7) de structure de moins de 250 nm, notamment de moins de 100 nm.

15. Procédé suivant la revendication 14, **caractérisé en ce qu'**on effectue l'attaque de la couche (2) en matière perméable à du rayonnement par attaque ionique réactive.

16. Procédé suivant l'une des revendications 15 à 18, **caractérisé en ce que** l'on dépose sur la couche (6) en matière imperméable à du rayonnement une couche d'oxyde, de carbure ou de nitrure.

17. Procédé suivant l'une des revendications 12 à 16, **caractérisé en ce que** l'on produit l'ouverture (8) de sortie par polissage chémiomécanique.

18. Procédé suivant l'une des revendications 13 à 17, **caractérisé en ce que** l'on règle la hauteur des parties de la couche (2) structurée dépassant de la matière (6) imperméable à du rayonnement par attaque en retrait de la couche (2) structurée ou par pulvérisation cathodique en retrait de la matière (6) imperméable à du rayonnement.

19. Procédé suivant l'une des revendications 12 à 18, **caractérisé en ce que** l'on met la couche (2) en matière perméable à du rayonnement sur un élément (3) de base.

20. Utilisation du dispositif suivant l'une des revendications 1 à 11 pour la production de couches structurées dans le domaine de la technologie des semi-conducteurs.

21. Utilisation du dispositif suivant la revendication 20 pour exposition dans le domaine optique proche avec maintien d'un intervalle défini entre l'ouverture (8) de sortie et la surface de la couche à structurer.

22. Utilisation du dispositif suivant la revendication 20 ou 21 pour l'exposition multiple de la couche à structurer, le dispositif étant déplacé entre les expositions d'une distance donnée à l'avance.
